# EUROPÄISCHE PATENTSCHRIFT

(11) **EP 0 970 525 B1**
(45) Veröffentlichungstag und Bekanntmachung des Hinweises auf die Patenterteilung: **21.05.2003**
(21) Anmeldenummer: 98909291.1
(22) Anmeldetag: 28.01.1998
(51) Int. Cl.: H01L 29/74, H01L 29/36, H01L 31/111

(54) **ASYMMETRISCHER THYRISTOR**
ASYMMETRICAL THYRISTOR
THYRISTOR ASYMETRIQUE

(30) Priorität: 31.01.1997 DE 19703673
(43) Veröffentlichungstag der Anmeldung: 12.01.2000
(73) Patentinhaber: Infineon Technologies AG, 81669 München (DE)
(72) Erfinder: SCHULZE, Hans, Joachim, D-85521 Ottobrunn (DE)
(74) Vertreter: Patentanwälte Westphal, Mussgnug & Partner
(86) Internationale Anmeldenummer: DE9800248
(87) Internationale Veröffentlichungsnummer: WO98034282

(56) Entgegenhaltungen:
- EP-A- 0 316 881
- GB-A- 1 436 411
- PATENT ABSTRACTS OF JAPAN vol. 011, no. 033 (E-476), 30.Januar 1987 -& JP 61 202465 A (TOSHIBA CORP), 8.September 1986,
- MITLEHNER H ET AL: "HIGH VOLTAGE THYRISTOR FOR HVDC TRANSMISSION AND STATIC VAR COMPENSATORS" PROCEEDINGS OF THE 19TH ANNUAL POWER ELECTRONICS SPECIALISTS CONFERENCE (PESC), KYOTO, 11. - 14. APRIL 1988, Bd. 2, INSTITUTE OF ELECTRICAL AND ELECTRONICS ENGINEERS, Seiten 934-939, XP000044744 in der Anmeldung erwähnt

## Beschreibung

### 1. Einleitung

Sowohl die Sperrspannung als auch die Kippspannung (Blockierspannung, ab der der Thyristor in den leitenden Zustand übergeht) eines Thyristor zeigen ein ausgeprägtes Temperaturverhalten. So steigen die Sperr- und die Kippspannung zunächst mit der Temperatur kontinuierlich an, erreichen ein Maximum, um schließlich auf vergleichsweise kleine Werte abzusinken. Während bei niedrigen und mittleren Temperaturen der Einfluß des positiven Temperaturkoeffizienten der die Elektronenvervielfachung durch Stoßionisation charakterisierenden Avalanchekoeffizienten überwiegt, läßt sich das Absinken der Sperr- und Kippspannung bei höheren Temperaturen T ≥ 100°C auf die Dominanz des positiven Temperaturkoeffizienten der Transistor-Stromverstärkung αₚₙₚ als Folge des stark ansteigenden Sperrstroms zurückführen. Besonders störend wirkt die Temperaturabhängigkeit der Sperr- und Kippspannung in hochsperrenden Thyristoren, welche einen in den Halbleiterkörper integrierten Schutz gegen das Überkopfzünden aufweisen. Bei diesen Thyristoren können die Sperr- und die Kippspannung im relevanten Temperaturbereich (5°C-120°C) sich bis zu 15% ändern. So steigt die Kippspannung beispielsweise von U_{BO} = 8,0 kV auf Werte U_{BO} ≈ 9,2 kV an, wenn sich der Thyristor während des Betriebes von T = 23°C auf T = 90°C erwärmt.

Der Anwender muß diesem Effekt durch eine aufwendigere Beschaltung des Thyristors Rechnung tragen. Der Hersteller des Bauelements ist demgegenüber gezwungen, die Streuung der die Sperr- bzw. Kippspannung beeinflussenden Parameter (Grunddotierung des Si-Substrats, Dotierstoffprofile, Kontur des Randabschlusses usw.) äußerst klein zu halten. Aufgrund damit einhergehenden hohen technologischen Aufwandes bei gleichzeitig verringerter Ausbeute verteuert sich die Produktion erheblich.

Aus Patent Abstracts of Japan, Bd. 11, Nr. 33 (E-476), 30. Januar 1987, & JP-A-61 202 465 ist ein Thyristor bekannt, der einen kathodenseitigen Emitter, eine kathodenseitige Basis, eine anodenseitige Basis und einen anodenseitigen Emitter aufweist, wobei eine lichtempfindliche Struktur in der kathodenseitigen Basis realisiert ist. Zwischen der anodenseitigen Basis und dem anodenseitigen Emitter ist teilweise eine stark dotierte Zone vom selben Leitungstyp wie die anodenseitige Basis vorgesehen, wobei diese stark dotierte Zone unterhalb der lichtempfindlichen Struktur jedoch nicht vorhanden ist, um dort einen Durch-bruchsbereich des "punch through"-Typs zu bilden.

### 2. Gegenstand/Vorteile der Erfindung

Gegenstand der Erfindung ist ein asymmetrischer Thyristor mit den in Patentanspruch 1 angegebenen Merkmalen, dessen Kippspannung nicht oder nur noch unwesentlich von der Temperatur abhängt. Erreicht wird dies durch eine lateral inhomogene Verteilung des Dotierstoffes in der Stoppzone der anodenseitigen Basis. Eine Stoppzone mit einem vergleichsweise schwach dotierten Zentralbereich und einem höher dotierten Außenbereich läßt sich einfach und kostengünstig herstellen ("maskierte" Implantation).

### 3. Zeichnungen

Die Erfindung wird im folgenden anhand der Zeichnungen erläutert, wobei
Figur 1 ein Ausführungsbeispiel des erfindungsgemäßen Thyristors im Querschnitt und
Figur 2 das Dotierstoffprofil des asymmetrischen Thyristors unterhalb der Kathodenmetallisierung zeigen.

### 4. Beschreibung eines Ausführungsbeispiels

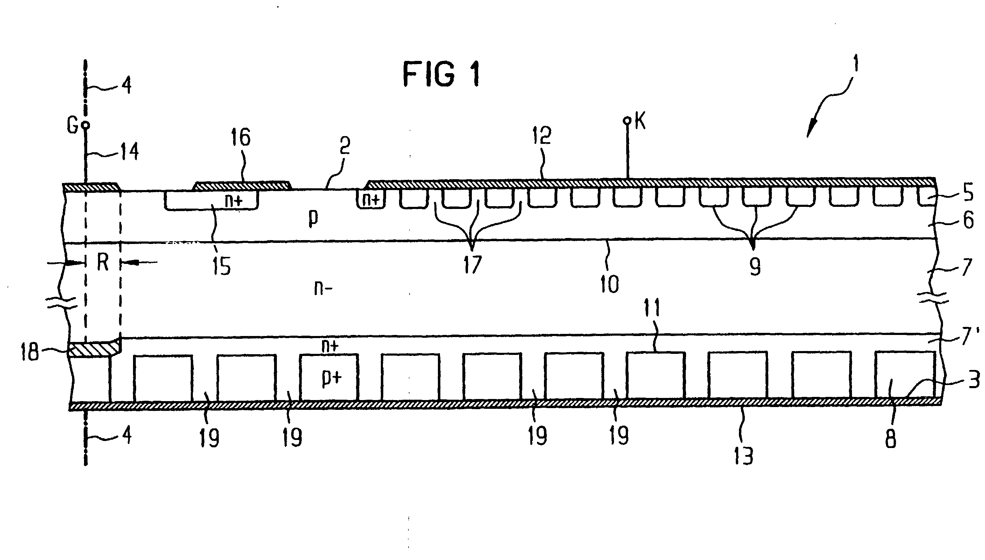

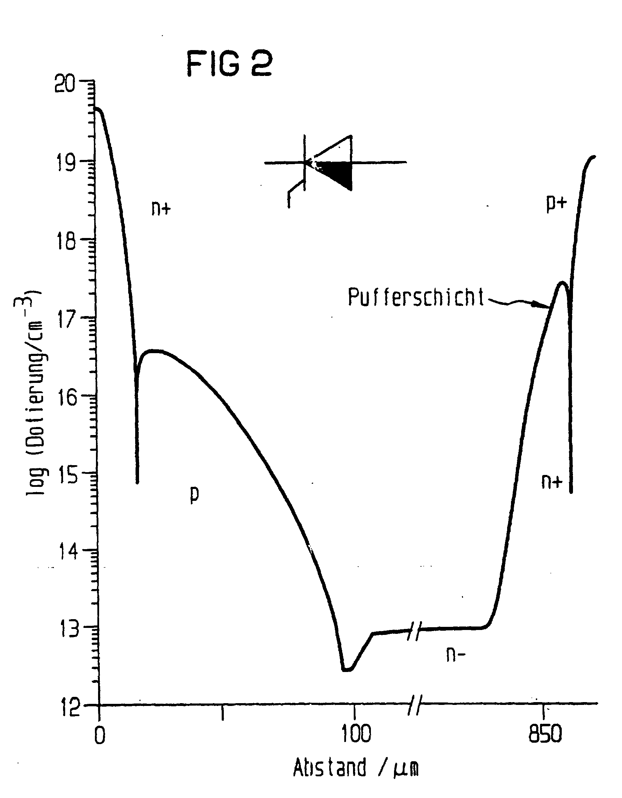

Der in Figur 1 im Querschnitt dargestellte Thyristor besitzt einen rotationssymmetrischen Aufbau bezüglich der auf den beiden Hauptflächen 2/3 des Halbleiterkörpers 1 senkrecht stehenden Achse 4. Der scheibenförmige, aus Silizium bestehende Halbleiterkörper 1 weist mehrere, unterschiedlich dotierte und jeweils durch pn-Übergänge 9-11 getrennte Bereiche 5-8 mit den in Figur 2 dargestellten Dotierstoffprofilen auf. Diese Bereiche unterschiedlicher eitfähigkeit bilden den von der Kathode 12 kontaktierten n⁺-Emitter 5, die kathodenseitige p-Basis 6, die nur schwach elektronenleitende und mit einer n⁺-Stoppzone 7' (Buffer Layer) versehene n-Basis 7 sowie den von der Anode 13 kontaktierten p⁺-Emitter 8 des Thyristors. Um den Einfluß des Leckstromes auf den Transistorverstärkungsfaktor αₚₙₚ bei geringen Leckstromdichten zu unterdrücken, ist der p⁺-Emitter 8 vorteilhafterweise mit Anodenkurzschlüssen 19 ausgestattet. Die zwischen der Gate-Elektrode 14 und der Kathode 12 angeordnete Struktur 15/16 wird üblicherweise als "Amplifying Gate" bezeichnet. Sie besteht aus einem in die kathodenseitige Basis 6 eingebetteten, n⁺-dotierten Bereich 15 (Hilfsemitter) und einer sowohl den n⁺-dotierten Bereich 15 als auch die p-Basis 6 kontaktierenden Metallisierung 16. Im Zusammenwirken mit den darunterliegenden Halbleiterschichten und der Anode 13 bildet diese Struktur 15/16 einen als Treiberstufe für den Hauptthyristor dienenden Hilfs- oder Pilotthyristor, der den über die Gate-Elektrode 14 in die p-Basis 6 eingespeisten Steuerstrom erheblich verstärkt. Die im Bereich der Kathode 12 vorhandenen Emitterkurzschlüsse 17 gewährleisten, daß der Thyristor auch bei einer großen dU/dt-Belastung von einigen 1000 V/µs nicht bereits vor dem Erreichen der statischen Kippspannung unkontrolliert zündet.

Die Überkopfzündung des erfindungsgemäßen Thyristors wird nicht durch einen Lawinendurchbruch (Avalanche), sondern durch den sogenannten "punch through"-Effekt erzwungen. Als "punch through" ist in diesem Fall die Ausdehnung der Raumladungszone des in Sperrichtung gepolten p-Basis-/n-Basis-Übergangs 10 bis hin zum benachbarten, in Durchlaßrichtung gepolten n-Basis-/p-Emitter-Übergang 11 und dem daraus resultierenden steilen Anstieg des Leckstroms innerhalb der die beiden pn-Übergänge 10/11 umfassenden Halbleiterstruktur zu verstehen. Da dieser den Durchbruch herbeiführende Effekt im wesentlichen nur noch von der Grunddotierung und der Dicke der n-Basis 7 und nicht mehr von der Temperatur abhängt, ändert sich auch die Kippspannung im Bereich der Betriebstemperaturen (5°C-120°C) nicht mehr oder nur noch unwesentlich. Um sicherzustellen, daß die durch "punch through" ausgelöste Zündung im Zentrum des Thyristors einsetzt, ist die Dotierstoffkonzentration der n⁺-Stoppzone 7' in dem unterhalb der Gate-Elektrode 14 liegenden Bereich 18 (Radius R ≈ 1 - 3 mm) gegenüber dem lateral angrenzenden und sich bis zum Scheibenrand erstreckenden Bereich der Stoppzone 7' deutlich verringert. Die vergleichsweise schwache Dotierung im Zentralbereich 18 der Stoppzone 7' bewirkt, daß sich dort die dem pn-Übergang 10 zugeordnete Raumladungszone beim Anlegen einer hohen Kippspannung bis hin zum p⁺-Emitter 8 ausdehnt, der Sperrstrom demzufolge stark ansteigt und der zentrale Thyristorbereich in den leitenden Zustand übergeht. In den lateral angrenzenden Bereichen des Bauelements kann die Raumladungszone den n-Basis-/p-Emitter-Übergang 11 aufgrund der höheren Dotierung der n⁺-Stoppzone 7' hingegen nicht erreichen, was einen "punch through"bedingten Stromanstieg verhindert.

Herstellen läßt sich die lateral inhomogene Verteilung des Dotierstoffes in der n⁺-Stoppzone 7' beispielsweise durch eine anodenseitig vorgenommene, zweistufige Implantation mit Donatoratomen (üblicherweise Phosphoratome). Das entsprechende Verfahren ist durch die folgenden Schritte gekennzeichnet:
- ganzflächige, anodenseitige Implantation von Phosphorionen mit einer Dosis von beispielsweise 0,3 - 2 • 10¹² cm⁻², welche "punch through" ermöglicht;
- Aufbringen einer als Implantationsmaske dienenden Fotolackoder SiO₂-Schicht der Dicke d = 1 µm im Zentralbereich des Halbleiterkörpers 1;
- anodenseitige maskierte Implantation von Phosphorionen mit einer Dosis von beispielsweise 3 - 10 • 10¹⁴ cm⁻², welche "punch through" verhindert;
- Ablösen der Fotolack- oder SiO₂-Schicht und
- Eindiffundieren der Phosphoratome bei hoher Temperatur (T ≈ 1240 °C) innerhalb einer Zeitspanne von etwa 10-30 Stunden.

Über die Dotierung der n⁺-Stoppzone 7' außerhalb des Zentralbereichs 18 kann man bei vorgegebener Dotierstoffkonzentration im p⁺-Emitter 8 die Transistorverstärkung αₚₙₚ und damit auch die Höhe der Blockierspannung sowie die Durchlaßspannung des Thyristors beeinflussen (s. PESC 88 Record (April 1988), S. 934 - 939 (Mitlehner et al.)). Hierbei gilt es allerdings zu beachten, daß die die Dotierstoffkonzentration bestimmende Phosphor-Implantationsdosis nur in einem relativ engen Bereich variiert werden kann, um die geforderte hohe Blockierspannung (αₚₙₚ möglichst klein) bei gleichzeitig niedriger Durchlaßspannung (αₚₙₚ möglichst groß) zu gewährleisten.

Die obigen Ausführungen betreffen einen gategesteuerten Thyristor. Selbstverständlich läßt sich auch die Temperaturabhängigkeit der Kippspannung eines lichtzündbaren asymmetrischen Thyristors deutlich verringern, indem man den unterhalb der strahlungsempfindlichen Thyristorstruktur liegenden Bereich der Stoppzone schwächer dotiert als den lateral angrenzenden Bereich.

## Patentansprüche

1. Asymmetrischer Thyristor mit dem folgenden Aufbau:
a) Er besitzt einen mit einer als Kathode dienenden ersten Elektrode (12) und einer als Anode dienenden zweiten Elektrode (13) versehenen Halbleiterkörper (1), wobei der Halbleiterkörper (1) mehrere unterschiedlich dotierte Bereiche (5-8) aufweist;
b) die Dotierung und Lage der Bereiche (5-8) sind derart vorgegeben, daß die Bereiche einen kathodenseitigen Emitter (5) eines ersten Leitungstyps, eine kathodenseitige Basis (6) eines zweiten Leitungstyps, eine anodenseitige Basis (7) des ersten Leitungstyps und einen anodenseitigen Emitter (8) des zweiten Leitungstyps bilden;
c) in der anodenseitigen Basis (7) befindet sich eine Stoppzone (7') des ersten Leitungstyps;
dieser Thyristor ist
**dadurch gekennzeichnet**, d a ß
die Stoppzone (7') einen unterhalb eines Zündkontaktes (14) oder einer lichtempfindlichen Struktur liegenden Zentralbereich (18) und einen lateral daran angrenzenden Bereich aufweist,
die Stoppzone (7') in dem Zentralbereich schwächer dotiert ist als im lateral angrenzenden Bereich und
der anodenseitige Emitter (8) mit Anodenkurzschlüssen (19) versehen ist.

2. Asymmetrischer Thyristor nach Anspruch 1,
**dadurch gekennzeichnet,**
**daß** die Dotierung des zentralen Bereichs (18) und des lateral angrenzenden Bereichs der Stoppzone (7') derart gewählt sind, daß die Raumladungszone des die kathodenseitige und die anodenseitige Basis (6/7) trennenden pn-Übergangs (10) den anodenseitigen pn-Übergang (11) bei einem vorgegebenen Wert der Differenz des Kathoden- und Anodenpotentials ausschließlich im Zentralbereich des Halbleiterkörpers (1) erreicht.

3. Asymmetrischer Thyristor nach Anspruch 1 oder 2,
**dadurch gekennzeichnet,**
**daß** eine auf einer kathodenseitigen Hauptfläche (2) des Halbleiterkörpers (1) angeordnete Metallisierung (16) sowohl die kathodenseitige Basis (6) als auch einen in die kathodenseitige Basis (6) eingebetteten Hilfsemitter (15) des ersten Leitungstyps kontaktiert.

4. Asymmetrischer Thyristor nach einem der Ansprüche 1 bis 3,
**dadurch gekennzeichnet,**
**daß** die Stoppzone (7') eine lateral inhomogene Verteilung aufweist, die durch Implantation eines Dotierstoffes erzeugt wird, wobei die Dosis des Dotierstoffes im zentralen Bereich der Stoppzone (7') um einen Faktor 100-5000 niedriger ist als im lateral angrenzenden Bereich.

5. Asymmetrischer Thyristor nach Anspruch 4,
**dadurch gekennzeichnet,**
**daß** die Dosis des Dotierstoffes im zentralen Bereich (18) der Stoppzone (7') 0,3 - 2 • 10¹² cm⁻² beträgt.

## Claims

1. Asymmetrical thyristor having the following construction:
a) it has a semiconductor body (1) provided with a first electrode (12), serving as cathode, and a second electrode (13), serving as anode, the semiconductor body (1) having a plurality of differently doped regions (5-8);
b) the doping and position of the regions (5-8) are prescribed in such a way that the regions form a cathodal emitter (5) of a first conduction type, a cathodal base (6) of a second conduction type, an anodal base (7) of the first conduction type and an anodal emitter (8) of the second conduction type;
c) a stop zone (7') of the first conduction type is situated in the anodal base (7);
this thyristor is **characterized in that**
the stop zone (7') has a central region (18) located below a triggering contact (14) or a light-sensitive structure, and a region laterally adjoining the said central region,
the stop zone (7') is doped more weakly in the central region than in the laterally adjoining region, and
the anodal emitter (8) is provided with anode short-circuits (19).

2. Asymmetrical thyristor according to Claim 1,
**characterized**
**in that** the doping of the central region (18) and the doping of the laterally adjoining region of the stop zone (7') are chosen in such a way that the space charge zone of the pn junction (10) separating the cathodal and the anodal base (6/7) reaches the anodal pn junction (11) at a predetermined value of the difference between the cathode and anode potentials exclusively in the central region of the semiconductor body (1).

3. Asymmetrical thyristor according to Claim 1 or 2,
**characterized**
**in that** a metallization (16) arranged on a cathodal main area (2) of the semiconductor body (1) makes contact with both the cathodal base (6) and an auxiliary emitter (15) of the first conduction type, which auxiliary emitter is embedded in the cathodal base (6).

4. Asymmetrical thyristor according to one of Claims 1 to 3,
**characterized**
**in that** the stop zone (7') has a laterally inhomogeneous distribution produced by implantation of a dopant, the dose of the dopant being a factor of 100-5000 lower in the central region of the stop zone (7') than in the laterally adjoining region.

5. Asymmetrical thyristor according to Claim 4,
**characterized**
**in that** the dose of the dopant in the central region (18) of the stop zone (7') is 0.3 - 2 • 10¹² cm⁻².

## Revendications

1. Thyristor asymétrique ayant la structure suivante :
a) un corps semi-conducteur (1) ayant une première électrode (12) servant de cathode et une seconde électrode (13) servant d'anode, le corps semi-conducteur (1) ayant plusieurs zones à dopages différents (5 - 8) ;
b) le dopage et la position des zones (5 - 8) sont prédéfinis pour que les zones forment un émetteur (5) du côté de la cathode ayant un premier type de conductivité, une base du côté de la cathode (6) ayant un second type de conductivité, une base du côté de l'anode (7) ayant une conductivité du premier type et un émetteur (8) du côté de l'anode ayant une conductivité du second type ;
c) la base (7) du côté de l'anode comporte une zone d'arrêt (7') du premier type de conductivité,
**caractérisé en ce que**
la zone d'arrêt (7') présente une zone centrale (18) située en dessous d'une zone de contact (14) ou d'une structure photo-sensible et une zone adjacente latéralement,
la zone d'arrêt (7') de la zone centrale est dopée plus faiblement que la zone latérale adjacente, et
l'émetteur (8) du côté de l'anode est muni de courts-circuits d'anodes (19).

2. Thyristor asymétrique selon la revendication 1,
**caractérisé en ce que**
le dopage de la zone centrale (18) et de la zone latérale adjacente de la zone d'arrêt (7') sont choisies pour que la zone de charge d'espace de la jonction pn (10) séparant la base du côté de la cathode et celle du côté de l'anode (6/7), atteigne la jonction pn (11) du côté de l'anode pour une valeur prédéterminée de la différence du potentiel de la cathode et celui de l'anode, exclusivement dans la zone centrale du corps semi-conducteur (1).

3. Thyristor asymétrique selon la revendication 1 ou 2,
**caractérisé par**
une métallisation (16) prévue sur une surface principale (2) du corps semi-conducteur (1) du côté de la cathode, et qui est en contact à la fois avec la base (6) du côté de la cathode qu'avec un émetteur auxiliaire (15) du premier type de conductivité, noyé dans la base (6) du côté de la cathode.

4. Thyristor asymétrique selon l'une des revendications 1 à 3,
**caractérisé en ce que**
la zone d'arrêt (7') présente une distribution latérale non homogène créée par implantation d'un dopant, et la dose du dopant dans la zone centrale de la zone d'arrêt (7') est inférieure d'un coefficient 100 - 5000 à la concentration dans la zone latérale adjacente.

5. Thyristor asymétrique selon la revendication 4,
**caractérisé en ce que**
la dose du dopant dans la zone centrale (18) de la zone d'arrêt (7') correspond à 0,3 - 2 • 10¹² cm⁻².
